Europäisches Patentamt

European Patent Office

Office européen des brevets

Publication number: **0 295 344**
A1

# EUROPEAN PATENT APPLICATION

Application number: **87305394.6**

Int. Cl.⁴ **G03F 7/00 , G03C 1/68**

Date of filing: **17.06.87**

Date of publication of application:
**21.12.88 Bulletin 88/51**

Designated Contracting States:
**BE DE FR GB IT**

Applicant: **THE MEAD CORPORATION**
**Mead World Headquarters Courthouse Plaza**
**Northeast**
**Dayton Ohio 45463(US)**

Inventor: **Davis, Paul D.**
**9904 Redbarn Trail**
**Centerville Ohio 45463(US)**
Inventor: **O'Connor, Joseph G.**
**2845 Westminster**
**Springboro Ohio 45066(US)**

Representative: **Deans, Michael John Percy et al**
**Lloyd Wise, Tregear & CO. Norman House**
**105-109 Strand**
**London WC2R OAE(GB)**

Imaging material and an image-forming process.

An imaging material comprises a support and a layer of photosensitive microparticles on one surface of the support. The microparticles include an image-forming agent such as a dye or a colour precursor, and a photosensitive composition containing a depolymerizable polymer such as a polyaldehyde. By exposing the microparticles to radiation, they release the image-forming agent or become permeable to a developer which reacts with the image-forming agent to form a visible image.

FIG-4

## IMAGING MATERIAL AND AN IMAGE-FORMING PROCESS

The present invention relates to imaging systems capable of forming images. Embodiments of systems which produce monochromatic images and which produce full colour images are described.

Imaging systems employing photosensitive microcapsules are known in the art. An early version of these systems is described in U. S. Patent 3,219,446 to Berman. More recently, Sanders et al. have described an imaging system in U. S. Patents 4,399,309 and 4,440,846 in which a chromogenic material is encapsulated with a photohardenable or photosoftenable composition. In this system, the microcapsules are image-wise exposed to actinic radiation and subjected to a uniform rupturing force whereupon they image-wise release a chromogenic material which reacts with a developer to form a full colour or a monochromatic image.

Japanese Patent Publication 34488/1977 also discloses a photosensitive material including microcapsules. Therein, a chomogenic material is encapsulated in a wall material containing a photosensitive substance which generates a gas by photodecomposition. Upon exposure, the microcapsules release the chomogenic material whereupon it reacts with a developer, which is present in the microcapsule layer, to form the image.

The present invention provides, in one aspect thereof, an imaging material which comprises a support having a layer of photosensitive microparticles on the surface which contain an image-forming agent. The microparticles are formed from a photosensitive composition containing a depolymerizable polymer which has an image-forming agent admixed therewith. The microparticles are designed such that they release the image-forming agent or permit the image-forming agent to react with a developer if they are exposed to actinic radiation. In one embodiment of the imaging material, the image-forming agent is a chromogenic material and a developer material is associated with the photosensitive material such that, after exposure, the chromogenic material reacts with the developer and forms a visible image.

In a second and alternative aspect of this invention, there is provided an image-forming process which comprises: image-wise exposing to radiation an imaging material, characterised in that said imaging material comprises a support and a layer of photosensitive microparticles on one surface of said support, said microparticles including an image-forming agent and a photosensitive composition containing a depolymerizable polymer.

Photosensitive material in accordance with the present invention has the advantage that it is a negative-working material. It is only necessary to expose the material to radiation in the areas in which an image is desired, i.e., in the image areas. Non-image or background areas in which no colour is desired remain white in the absence of exposure. These materials are particularly advantageous for imaging by laser scanners and the like, because the scanner can pass over the non-image areas. By contrast, the most typical of the photosensitive materials described in the aforementioned Sanders' patents employ photohardenable compositions. These materials are positive-working. To achieve Dmin, they must be fully exposed in the non-image areas in order to lock the chromogenic material in the capsule and prevent its reaction with the colour developer. These materials are not desirable for use with scanning-type exposure devices because both image and non-image areas must be exposed. The image areas require exposure to the extent that only a partial release of the chromogenic material in the image areas is desired. The non-image areas require a full exposure to achieve Dmin. Furthermore, the photohardenable compositions which have been developed for use in the Sanders' materials have comparatively low sensitivity. As a consequence of the need to fully expose a large area of the photosensitive material and the comparatively low sensitivity of the photohardenable compositions, long exposure periods are required to expose the positive-working embodiment of the Sanders' material using a scanner device.

A further advantage of the photosensitive materials of the present system is handleability. Because the microparticle is solid, inadvertent release of the image-forming agent in the course of handling is not nearly as likely to occur as it is using photosensitive microcapsules which readily rupture. Embodiments of our photosensitive material which produce full colour images also have the advantage that they can provide such images from a single photosensitive layer as contrasted with silver halide materials which include a plurality of layers.

Another advantage of preferred embodiments of our imaging material is their relative insensitivity to oxygen. In many cases depolymerization is initiated by a photogenerated acid which reacts directly with the depolymerizable polymer. In systems in which imaging occurs via free radical polymerization, the oxygen in the photosensitive composition must be consumed by free radicals before polymerization proceeds. Oxygen does not affect the depolymerization chemistry relied upon in most embodiments.

The photosensitive microcapsules used in the practise of the present invention may be distinguished from the Sanders' materials and, more particularly, Sanders' materials employing photosoftenable compositions, in that the microparticles used herein do not include a microcapsule wall. Furthermore, in preferred embodiments the microparticles are formed from a photosensitive composition of a polyaldehyde.

As mentioned above, the invention extends to embodiments in which the imaging material is used to form full colour images. This can be accomplished in two ways. One method is to form full colour transfer images using three separate imaging sheets on which the microparticles respectfully contain cyan, magenta, and yellow colour-forming chromogenic materials. By sequentially exposing the three sheets and conducting successive transfers in register to an image-receiving sheet carrying a developer material, the cyan, magenta, and yellow colour-forming chromogenic materials are image-wise transferred to the surface of the developer sheet where they react to form a full colour image.

In another embodiment of full colour photosensitive imaging material also in accordance with the present invention, the layer of microparticles includes three, and in some cases four, sets of microparticles. Each set of microparticles contains a different chromogenic material and is selectively sensitive to a different band of actinic radiation. The distinct sets of microparticles respectively contain cyan-, magenta-, and yellow-forming chromogenic materials or cyan-, magenta-, yellow-, and black-forming chromogenic materials. The photosensitive compositions from which the microparticles are formed are designed with distinctly different wavelength sensitivities such that, at selected wavelengths, each set of microparticles can be exposed such that it releases the image-forming agent and/or permits it to react with a developer without cross-exposing the other sets of microparticles.

The latter full colour imaging material is advantageous because the microparticles are image-wise exposed on the surface of a single imaging sheet. The visible image can be developed using any of the development techniques described later including one embodiment in which the developer material is present on the same surface of the image sheet as the microparticles and one embodiment in which the developer material is provided on a separate image-receiving sheet. After image-wise exposing the imaging material to actinic radiation sequentially or simultaneously in each of the regions in which the respective sets of microparticles are sensitive, the microparticles image-wise release the chromogenic materials (directly or with additional processing) or otherwise enable the chromogenic material to react with a developer.

The term "microparticle" is used herein in respect of a particle formed from an admixture of an image-forming agent and a photosensitive composition containing a depolymerizable polymer. The term "microparticle" is to be distinguished from the term "microcapsule" which is defined in U.S. Patents 4,399,209 and 4,440,846 as a capsule having a discrete capsule wall or an encapsulated dispersion of a photosensitive composition in a binder.

The term "radiation" as used herein includes the full spectrum of electromagnetic radiation including actinic radiation such as ultraviolet, infrared, and visible light, as well as ionizing and particle radiation.

The term "depolymerizable polymer" as used herein includes polymers which either become depolymerized or decrosslinked in the presence of products generated upon exposing the photosensitive composition to radiation. The polymers themselves may be photosensitive. That is, the polymers may be photolyzable and depolymerize directly upon exposure to radiation. Otherwise, the polymers may be non-photosensitive, in which case another photosensitive species such as a photoinitiator must be present in the photosensitive composition.

In the drawings:

Fig. 1 is a schematic illustration in cross-section of an imaging material in accordance with one embodiment of the present invention;

Fig. 2 schematically illustrates image-wise exposure of an imaging material in accordance with the present invention;

Fig. 3 illustrates an imaging material in accordance with the present invention following exposure or following an optional treatment to cause the exposed microparticles to release the image-forming agent;

Fig. 4 illustrates a visible image formed in an imaging material in accordance with one embodiment of the present invention;

Fig. 5 is a block diagram illustrating one full color imaging process in accordance with the present invention; and

Fig. 6 is a block diagram illustrating another full color imaging process in accordance with the present invention.

A photosensitive material in accordance with the present invention, in its simplest form 10, comprises a support 12 and a layer 14 of microparticles 16. The microparticles 16 are formed from a photosensitive composition containing a depolymerizable polymer which is admixed with an image-forming agent as discussed below.

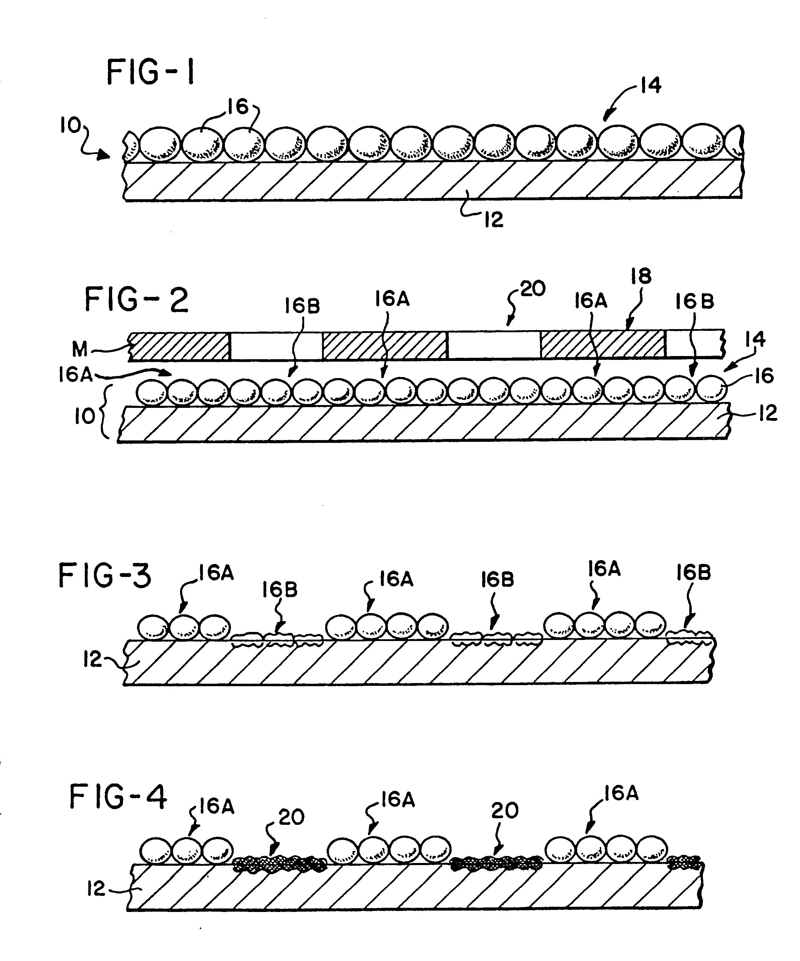

In Fig. 2, the photosensitive material 10 is shown being exposed to actinic radiation (designated h λ) through a mask M to form a latent image in the form of unexposed and exposed microparticles 16A and 16B. After exposure. the manner of processing will depend on the nature of the microparticle and the image-forming agent. The microparticles 16A in the unexposed areas 18 are unchanged. The microparticles 16B in the exposed areas 20 undergo a change which enables the image-forming agent to be released or exuded from the microparticle or simply to react with a developer to form a visible image. The change may occur directly upon exposure or, depending upon the composition of the microparticle, the change may occur upon heating, application of pressure. or like treatment.

Images are formed by one of two mechanisms. The image-forming agent may be released from the microparticles or the microparticles may become permeable to a developer material. Where transfer images are formed. the image-forming agent (e.g., a benign dye or a chromogenic compound) must be released from the microparticles. In self-contained systems or systems in which the developer is applied externally, either mechanism is useful.

Fig. 3 represents the photosensitive material 10 after exposure and, in most cases, after an optional step of treating the microparticles to facilitate the release of the image-forming agent or its accessibility to a developer. In Fig. 3, the unexposed microparticles 16A are shown as retaining their original form, whereas, the exposed microparticles 16B are shown as having lost their form. The change in the morphology of microparticles 16B is shown for purposes of illustration only. In fact, there may be no visible change in the exposed microparticles.

Where the image-forming agent is a chromogenic material, that is, a material which becomes coloured upon reaction with a developer, it will be necessary to provide a developer. The developer can be provided using a number of techniques depending upon its nature and that of the chromogenic material. The developer may be incorporated into the layer of microparticles or into a contiguous layer to provide a self-contained imaging material. Images can be obtained using this type of material by simply exposing the material to radiation or exposing it to radiation and heating or otherwise inducing the reaction of the chromogenic material and the developer. The developer may penetrate the microparticle or the chromogenic material may exude from the microparticle in this type of development. Colour development processing, in accordance with the foregoing embodiment. is illustrated in Fig. 4. There. the image 20 is shown in the area of the exposed microparticle 16B. Where desirable, the developer can be microencapsulated or provided in a separate microparticle.

Another technique that can be used is to provide the developer on a separate support to which the chromogenic material is transferred. Images are formed by contacting the photosensitive material of Fig. 2 or Fig. 3 with the developer sheet such that the image-forming agent transfers to the developer sheet to form the image. In this case, heating and/or pressure can be combined with the transfer step to simultaneously cause the image-forming agent to be released from the microparticle and transfer to the developer sheet.

Alternatively, various external applications of developers can be used. The developing agent can be a gas with which the photosensitive material is contacted. Furthermore, while "dry" development processing (i.e., processing without external application of a developer) is clearly favoured, images can also be formed by contacting the photosensitive material of Fig. 3 with a solution of a developer. When the developer is applied externally, the developer may be a common developer which is capable of reacting with all the chromogenic materials, or a combination of developers may be used which respectively reacts with the different chromogenic materials.

In accordance with another embodiment of the invention, a toner may be applied which selectively adheres to the microparticles in the exposed areas.

When the microparticles contain a coloured image-forming agent, such as a dye or pigment, transfer may be the only step required to produce the image, i.e., no developer reaction is required. The exposed photosensitive material of Fig. 2 simply may be assembled with a transfer sheet, which could be plain paper or a paper treated to enhance its absorption of the dye or pigment, and transfer effected. In most cases, transfer will be effected simultaneously with the application of pressure and optionally heat to release and transfer the dye or pigment.

Those skilled in the art will appreciate from the foregoing discussion that while the process of the present invention has been illustrated in Figs. 2-4 as involving separate steps. the development steps need not be performed separately. Indeed. if the microparticle releases the image-forming agent directly upon exposure without additional processing and a developer is incorporated on the surface of the photosensitive material with the microparticle, the steps illustrated in Figs. 2-4 occur simultaneously. Typically, the steps illustrated in Figs. 3 and 4 will occur simultaneously.

The microparticles used in the present invention are formed from a photosensitive polymer composition containing a depolymerizable polymer which breaks down upon exposure to radiation. such that an image-forming agent incorporated in the polymer composition can react with a developer or be released from the microparticles. Useful depolymerizable polymers undergo free radical initiated or cationic depolymerization.

Representative examples of photosensitive compositions useful in the present invention are described in U.S. Patents 4,108,839; 3,984,253; 3,917,483; 3,915,704 and 3,127,811. These compositions contain polyaldehydes, but other depolymerizable compositions such as compositions containing polycarbonates as disclosed by Crivello, "Applications of Photoinitiated Cationic Polymerization to the Development of New Photoresists," Polymers in Electronics, ACS 242, p3 (1984) and Frechet et al., J. Imaging Science, 30 (2), p. 59 (1986); compositions containing polyethers as disclosed by Goethals, E.J., "The Formation of Cyclic Oligomers in the Cationic Polymerization of Heterocyclics," Adv. Poly. Sci., Vol. 23, p. 103; compositions containing poly(olefin sulfones) as disclosed by Hiraoka, H. "Deep U.V. Photolithography with Composite Photoresists Made of Poly-(olefin sulfones)," Polymers in Electronics, ACS 242, p. 55 (1984); Bowden, M.J., et al., ibid, pg. 135 and 153; and U.S. Patent 3,935,331 to Foliniak et al.; and compositions containing poly(3-oximino-2-butanone methacrylate) or poly(4'-alkyl acetophenones) as disclosed in Reichmanis, E., Am. Chem. Soc. Div. Org. Coat. Plast. Chem. Prepr., 1980, 43, 243-251 and Lukac, I., Chmela, S., Int. Conf. on Modif. Polym. 5th Bratislave, Czech., July 3-6, 1979, I.U.P.A.C. Oxford, England 1979, 1, 176-182) may be also be useful. Polysulfones of the type used in thermal transfer systems are also potentially useful.

Other potentially useful depolymerizable systems are the metal-crosslinked polymeric gels described in U.S. Patent 3,097,097 to Oster et al.; the compositions containing bichromated gelatin described in U.S. Patents 2,484,451 and 2,500,028 to Griggs; the photodegradable polyolefin compositions described in U.S. Patent 3,968,095 to Freeman et al.; compositions containing polymers having acid cleavable C-O-C groups as disclosed in U.S. Patent 4,421,844 to Buhr et al. such as polyalkylaryl ethers disclosed in U.S. Patet 4,435,496 to Walls et al.; compositions containing polyketones as described in U.S. Patents 3,923,514 to March and 4,419,506 to Nate et al. and by Tsuda et al. in U.S. Patent 4,297,433; compositions containing polymethacrylate such as those described in U.S. Patents 4,125,672 to Kakuchi and 3,779,806 to Gipstein et al.

Of the aforementioned depolymerizable systems, those which hold the most potential are those which combine an initiator which generates an acid upon exposure and an acid degradable polymer. For example, compositions employing initiators such as onium salts which undergo photolysis to produce strong acids which catalyze main chain scission of a polymer may be used. These systems are preferred to the others because a single photochemical event generates the acid which produces a number of bond transformations leading to complete or nearly complete reversion to the monomer. Included within this class of photodepolymerizable systems are compositions of acid degradeable polyaldehydes, polycarbonates and polyethers.

Another useful polymer is one which is crosslinked by an acid cleavable linking group. Exposure generates an acid as above which cleaves the linking group. Still another class of useful polymers are copolymers having acid degradable units or blocks in the polymer backbone.

The polyaldehydes which are useful in the present invention include poly(aromatic 1,2-dialdehydes), poly(aliphatic monoaldehydes), and copolymers thereof. These polymers undergo cationic depolymerization.

Polyaldehydes may be end-capped with a group which stabilizes the polymer to depolymerization. The end-capping group may be one which is photolabile and which separates from the polymer directly upon exposure to radiation, or be one which is acid cleavable, such as an ester or an ether group, and which separates from the polymer in the presence of a photogenerated acid. Alternatively, the polymer may be sufficiently stable to be processable into the microparticle without end-capping.

Polycarbonates which are potentially useful in practice of the present invention are described in the aforementioned papers of Crivello and Frechet. One useful polycarbonate is formed from the reaction of 2,5-dimethyl-2,5-hexanediol and 4,4-isopropyllidenediphenol.

Each microparticle includes an initiator which generates an acid, a cation, or a free radical which initiates depolymerization. The acid, cation, or free radical may be generated directly upon exposure or upon processing such as by heating. Where the system is silver catalyzed, a latent image in the form of the exposed silver halide may be formed and the cation generated subsequently upon heating or application of a developing agent. The initiator may be incorporated into the polymer chain, appended to the polymer chain, or simply mixed with the polymer.

Useful initiators include photogenerated acid precursors such as (i) triarylsulphonium hexafluorophosphates, triarylsulphonium arsenates and triarylsulphonium antimonates, (ii) diaryliodonium hexafluorophosphates, diaryliodonium arsenates and diaryliodonium antimonates, (iii) dialkyl-phenacylsulphonium tetrafluoroborates and dialkyl-phenacylsulphonium hexafluorophosphates, (iv)

dialkyl-4-hydroxyphenylsulphonium tetrafluoroborates and dialkyl-4-hydroxyphenylsulphonium hexafluorophosphates. Other useful initiators include halogen-containing compounds such as carbon tetrabromide, hexachloroethane, tribromoacetophenone, etc. and diazo compounds such as diazonium salts and o-quinonediazides, etc.

The foregoing compounds may be used alone or in combination with a sensitizer. Useful sensitizers for diaryliodonium compounds include Acridine Orange, Acridine Yellow, Phosphine R, Benzoflavin and Setoflavin T. Anthracene, perylene, phenothiazine, 1,2-benzanthracene, coronene, pyrene, and tetracene are useful sensitizers for triarylsulphonium arsenates, diaryliodonium arsenates and dialkylphenacyl sulphonium compounds. Ketocoumarins are also useful sensitizers. These sensitizers are used in conventional amounts.

In accordance with one embodiment of the present invention, cationic depolymerization is photoinitiated using an initiator system including a silver halide, an organo-silver salt, and, optionally, a reducing agent. Examples of each are provided in U.S. Patent 4,629,676. In the presence of the exposed silver halide, the silver salt releases an acid which initiates depolymerization.

Typical examples of silver salts useful in this embodiment of the present invention are silver behenate, silver alkanesulphonic acid salts, silver perfluoroalkanesulphonic acid salts, and silver $\beta$-hydroperfluoroalkanesulphonic acid salts. Examples are provided in U.S. Patents 3,347,676 and 4,504,575. More specific examples are silver dodecylsulphonate, silver hexadecylsulphonate, silver trifluoromethylsulphonate, silver pentafluoroethylsulphonate, silver perfluoropropylsulphonate, silver perfluoroctylsulphonate, $(CF_3)_2CHCF_2SO_3Ag$, and $n\text{-}C_3F_7CFHCF_2SO_3Ag$.

Hydroquinones, m-dimethylaminophenol and m-diethylaminophenol, are useful reducing agents.

Conventional photographic silver halides are useful herein including silver chloride, silver bromide, silver iodide, silver chlorobromide, silver chloroidide, silver iobobromide, and silver chloroiodobromide, and, more particularly, silver halides associated with a sensitizing dye. These reactions are accelerated by heating after exposure.

The microparticles of the present system can be used to control the release of various image-forming agents.

In a more preferred embodiment of the present invention, the microparticles can contain a benign visible dye and images are formed by contacting the exposed imaging material under pressure with a plain paper or a paper treated to enhance its affinity for the visible dye. A benign dye is a coloured dye which does not interfere with the imaging photochemistry, ie g., by relaxing the excited state of the initiator or detrimentally absorbing or attenuating the exposure radiation).

In another embodiment of the invention, images are formed through the reaction of a pair of chromogenic materials such as a colour precursor and a colour developer. In general, colour precursors include colourless electrondonating compounds having in their partial skeleton a lactone, a lactam, a sultone, a spiropyran, an ester or an amide structure such as triarylmethane compounds, bisphenylmethane compounds, xanthane compounds, fluorans, thiazine compounds, spiropyran compounds and the like. These materials are conventionally used in carbonless paper. Crystal Violet Lactone, 2,6-diphenyl-4-(4'-dimethylaminophenyl)-pyridine, and Copikem X, IV, and XI are a few examples.

The foregoing compounds are acid developable and therefore inherently basic. As such, they may compete with the polymer for the photogenerated acid in certain embodiments. Another type of chromogenic material which may be preferred for use in the present system is a base-developable chromogenic material. These materials are also leuco compounds and include the phenolphthaleins such as sulphobromophthalein sodium tetrahydrate, phenolphthalein, bromophenol blue, bromocresol green, bromocresol purple, and bromothymol blue.

In addition to carbonless paper-type colour precursors, colour photographic dye couplers can also be used as image-forming agents in accordance with the present invention. These materials may be developed using conventional phenolic or anilino photographic developers.

Diazonium salts are particularly useful image-forming agents because they react with unoxidized colour couplers to provide azo dye images. Examples of useful diazonium salts are: 4-diazo-N,N-diethylamino fluoroborate, 2-methoxy-4-morpholino benzene-diazonium chloride zinc chloride double salt, (3-chloro-6-methoxylienzene diazonium chloride zinc chloride double salt, 2,5-dethoxy-4-benzoylamide-benzenediazonium chloride zinc chloride double salt, (4-chloro-2-methylbenzene diazonium chloride zinc chloride double salt, 5-nitrothiazole diazonium hexafluorophosphat, and 4-nitrobenzene diazonium hexafluorophosphate.

Useful couplers include: 1-naphthol, 2-naphtol, 3-methyl-1-phenyl-2-pyrazoline-5-one, 3-methoxyphenol, 4-methoxyphenol, 1,3,5,-trimethoxybenzene, 1,3,-dimethoxybenzene, 2,3,-dihydroxynaphtalene, 1,3-dihydroxynaphthalene, 1-methoxynaphthalene, 2-methoxynaphthalene, 2-(α-cyanoacetyl)-benzofuran.

Examples of cyan, magenta and yellow image-forming dyes are disclosed in U.S. Patent 4,500,624.

Illustrative examples of the developer materials conventionally employed in carbonless paper technology which are also useful electron donating colour precursors in the present invention are clay minerals such as acid clay, active clay, attapulgite, etc.; organic acids such as tannic acid, gallic acid, propyl gallate, etc.; acid polymers such as phenol-formaldehyde resins, phenol acetylene condensation resins, condensates between an organic carboxylic acid having at least one hydroxy group and formaldehyde, etc.; metal salts or aromatic carboxylic acids such as zinc salicylate, tin salicylate, zinc 2-hydroxy naphthoate, zinc 3,5 di-tert butyl salicylate, zinc 3,5-di(α-methylbenzyl) salicylate, oil-soluble metal salts or phenol-formaldehyde novolak resins (e.g., see U.S. Patents 3,672,935; 3,732,120; and 3,737,410) such as zinc-modified oil-soluble phenol-formaldehyde resin as disclosed in U.S. Patent 3,732,120, zinc carbonate, etc., and mixtures thereof. Because these developers are acidic, in a self-contained system, they must be isolated from the microparticle. Otherwise, the developer may trigger undesirable depolymerization. One means to provide a self-contained material is to microencapsulate the developer in a separate microcapsule. The capsule containing the developer is then ruptured for development. Heatrupturable or pressure-rupturable capsules could be used.

To develop the base-developable chromogenic materials, weak bases such as sodium carboxylate or basic resins may be used.

Various methods can be used to form the microparticles for the present system. A solution of the depolymerizable polymer and other additives (e.g., the initiator, sensitizer, and image-forming agent) in a water-miscible or a water immiscible solvent can be added to an aqueous solution of a stabilizing agent (e.g., an anionic, amphoteric or ionic surfactant such as sodium lauryl sulfate; pectin; or polyvinyl alcohol) under high sheer mixing and the dispersion coated on a support and the water removed through drying. Where the solvent used is immiscible in water, it is preferably removed prior to coating.

Alternatively, a polymer melt containing the other additives can be dispensed into an aqueous solution of an appropriate surfactant without a solvent and the dispersion coated on an appropriate support. Another method which can be used to form the microparticles is spray drying. In one useful spray drying technique, a solution of the polymer and additives is aspirated into a heated air space.

To prepare silver catalyzed microparticles, a silver halide emulsion (e.g., stabilized with polyvinylbutyral) containing an organo silver salt may be dispersed into a solution or melt of the depolymerizable polymer and the microparticles formed by either of the methods described above.

The composition of the microparticles used in the present invention will vary depending upon the nature of the photosensitive composition and the image-forming agent. In particular, in forming full colour images, the composition of the mixture of microparticle will be adjusted to provide the appropriate colour balance. Generally, microparticles for use in our system may contain approximately 0.1 to 25 parts by weight of the image-forming agent per 100 parts by weight of the photosensitive composition and preferably 0.1 to 10 parts by weight.

A microparticle size should be selected which minimizes light attenuation. The mean diameter of the microparticles used in this invention typically ranges from approximately 1 to 25 microns. As a general rule, image resolution improves as the size decreases. If the microparticles become too small, they may disappear in the pores of the fibre of the substrate. These very small microparticles may therefore be screened from exposure by the substrate. It has been determined that a preferred mean microparticle diameter range is from approximately 3 to 15 microns, and particular, 3 to 10 microns.

The most common substrate for use in this invention is paper. The paper may be a commerical impact raw stock, or special grade paper such as cast-coated paper or chrome-rolled paper. Alternatively, transparent substrates such as poly-(ethylene terephthalate) can be used. Using a transparent substrate, the imaging material can be exposed from either the coated or uncoated side. A particularly preferred substrate is a thin transparent film.

The imaging materials of the present invention can be designed to provide monochromatic or full colour images. Image processing techniques are desirably used to form full colour images.

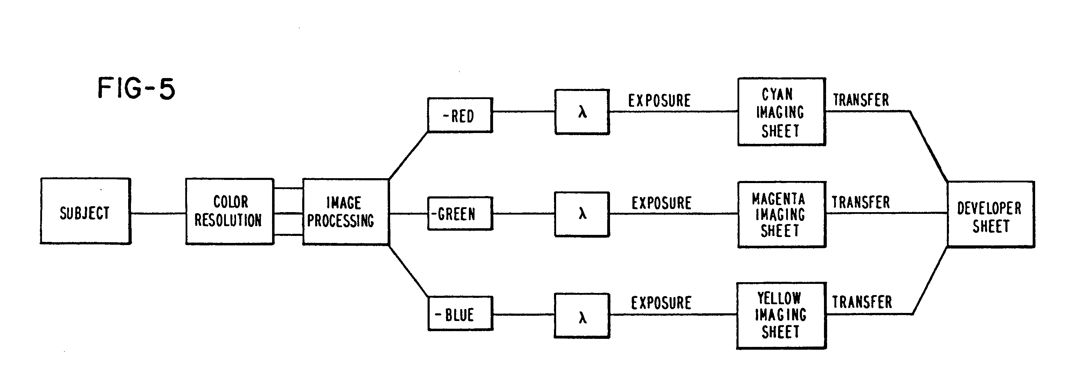

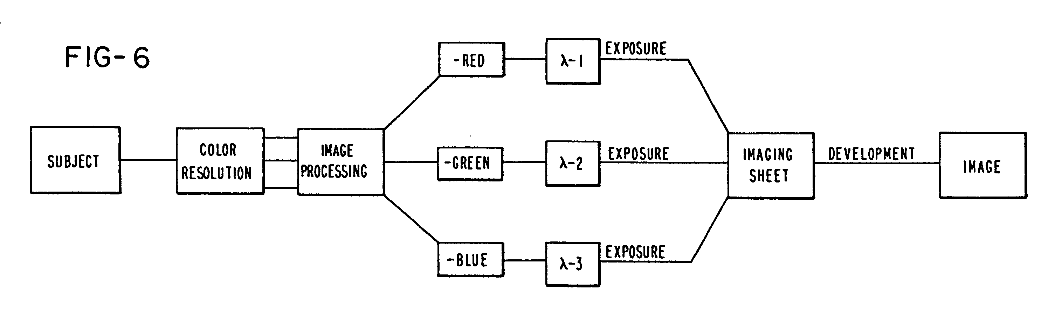

Figs. 5 and 6 are block diagrams illustrating two processes in accordance with the present invention for forming full colour images. As shown in Fig. 5, a colour original is resolved into its red, green, and blue component images. Because, in accordance with the most typical embodiment of the present invention, the photosensitive compositions are ultraviolet-sensitive or sensitive to blue or green light; the red, green, and blue component images are shown translated into radiation to which the microparticles are sensitive for exposure of three separate imaging sheets, each bearing microparticles which respectively contain cyan-, magenta-, and yellow-forming chromogenic materials. In accordance with this embodiment of the invention, apart from the chromogenic materials. the microparticles on the three imaging sheets can be identical. Thus, the red, green, and blue component images of the subject to be copied are inverted to produce reciprocal image information (i.e., -red, -green, and -blue) which are translated into the same wavelength band of actinic radiation.

As shown in Fig. 5, in addition to transforming the red, green, and blue component images into active radiation, image processing is used to correlate the component image with the exposure of the microparticles and the release of the image-forming agent. Since the microparticles are negative working, this involves an electronic inversion of the subject image to produce the reciprocal image. Thus, in areas corresponding to the red image, the magenta and yellow colour formers must be released to form a red image. In areas corresponding to the green image, yellow and cyan colour formers must be released, and in areas corresponding to the blue image, cyan and magenta colourformers must be released. To form full colour images, an original may be viewed with a Dunn or matrix camera and the red, green and blue channel outputs electronically inverted to provide reciprocal red (-red), reciprocal green (-green), and reciprocal blue (-blue) image information. This information is then used to drive the radiation source such that the colour formers are released by exposure of the three imaging sheets as described above.

In accordance with the foregoing embodiment of the invention, full colour images are formed by transfer processing. Thus, each of the exposed imaging sheets is contacted in face-to-face registration with a developer sheet to form the full colour image. As explained above, either directly as a consequence of exposure, or the combination of exposure and an additional treatment such as the application of heat or pressure, the microparticles image-wise release the chromogenic materials. Upon contact with the developer sheet, the cyan-, magenta-, and yellow-forming chromogenic materials are transferred to the developer sheet where they react to provide a full colour image.

The more preferred method for forming full colour images utilizes an imaging material in which the layer of microparticles is an admixture of three or four sets of microparticles respectively containing cyan-, magenta-, yellow-, and optionally, black-forming chromogenic materials. In accordance with this embodiment of the invention, the photosensitive compositions from which the microparticles are formed have distinctly different sensitivities to actinic radiation such that each set of microparticles can be exposed and caused to release the chromogenic material or become permeable to a developer without exposing the other sets of microparticles. In accordance with this embodiment of the invention, the microparticles may be formed from different photosensitive compositions containing different initiator systems. Imaging in accordance with this embodiment of the invention is shown in Fig. 6.

In Fig. 6, an original image is shown resolved into its red, green, and blue component images which, in accordance with the most typical embodiments of the invention, are processed (inverted) to produce reciprocal image information. In this embodiment, however, the exposure is at three wavelengths which are respectively indicated in Fig. 6 as $\lambda$ -1, $\lambda$ -2, and $\lambda$-3. In areas exposed to $\lambda$ -1, the microparticles sensitive to $\lambda$ -1 radiation release the cyan colour precursor. The microparticles sensitive to $\lambda$ -2 and $\lambda$ -3 radiations, however, do not release the colour precursors. In a parallel fashion, in areas exposed to $\lambda$ -2, the microparticles sensitive to $\lambda$ -2 release the magenta colour precursor; whereas, the microparticles sensitive to $\lambda$ -1 and $\lambda$ -3 radiations do not. In areas exposed to $\lambda$ -3 radiation, the microparticles sensitive to $\lambda$ -3 radiation release the yellow colour precursor; whereas, the microparticles sensitive to $\lambda$ -1 and $\lambda$ -2 radiation do not. In this manner, the microparticles image-wise release the colour precursors and, upon development processing as described above, full colour images are formed.

Colour images can also be formed in accordance with the present invention by using negative colour seps or separations. Each colour sep is mounted on the imaging sheet and an exposure is made at one of the wavelengths to which the microparticles are sensitive.

When the imaging material employs silver initiated microparticles, the imaging material is visible light sensitive. In this case, the imaging material may be exposed to visible light through a colour negative to form full colour positive images. Electronic image processing is not required.

The present invention will be illustrated in more detail by the following non-limiting Example.

Example

Polyphthalaldehyde is prepared by the method of C. Aso and S. Tagami (Macromolecular Synthesis, Collective Volume I, J.A. Moore, ed., 505 (1977)). Generally polymerizations are done in a 250 ml round bottom three-necked flask equipped with septum, overhead stirrer and a nitrogen inlet/thermometer adapter. The reaction vessel is furst purged with nitrogen with septum removed and dried with hot air gun until air temperature reaches 50° C. The reaction vessel is cooled, charged with phthalaldehyde (12.5 g). The septum is replaced and approximately 125 ml of methylene chloride, freshly distilled, is siphoned into the reaction vessel. The phthalaldehyde is dissolved and then cooled to dry ice-acetone temperatures. Some precipitation of monomer is always observed at this stage. With the solution stirring, BF₃OEt₂ catalyst in methylene chloride (1.3 to 1.4 percent on a molar basis of monomer) is added dropwise from a syringe. Some colouration is observed at this stage and precipitated monomer redissolves as polymerization proceeds. Polymerization at -75° C is continued for three hours at slow stirring rates. The polymerization is quenched with dry pyridine (3 g) and warmed to room temperature. Polyphthalaldehyde is purified by repeated precipitation into two parts methanol using a Waring blender.

The microparticles are prepared by an emulsification technique. The typical solvent and water phase used is:

## Solvent phase

| Polyphthalaldehyde | 5.0 g | |
| Diphenyliodonium hexafluorophosphate | | 0.5 g |
| Isopropyl thioxanthone | 0.05 g | |
| Methylene chloride | 50.0 g | |

## Water phase

| Pectin | 2.5 g |
| Water | 100 g |

The solvent phase is added rapidly to the water phase with high speed stirring (T-Line Laboratory Stirrer, Model 104 rated at 7500 rpm.) using a three bladed propeller type stirrer. The size of the dispersion is checked to insure particles less than 10 microns in size. A fritted glass sparger with nitrogen is introduced to evaporate the methylene chloride solvent. This requires approximately 1.5 hrs. The microparticle suspension is coated as is with a number 12 Meier rod on paper and dried with an air gun. Scanning electron photomicrographs of the coated surface confirm the presence of microparticles. Coulter counter analysis of the emulsion solution gave results of a 3.4 micron average particle size (1.3 to 16 micron range).

The coated sheet is baked for 1 minute at 100° C-120° C. A half-tone mask is placed over the sheet and exposed with a bank of three BLK-BP fluorescent bulbs (λ max - 390 nm) for 8 sec. The imaged sheet is developed in a chamber saturated with ammonium hydroxide vapours to produce a negative of the original mask.

## Claims

1. Imaging material characterised in comprising a support and a layer of photosensitive microparticles on one surface of said support, said microparticles including an image-forming agent and a photosensitive composition containing a depolymerizable polymer, said microparticles and said photosensitive composition being chosen such that, after exposing said microparticles to predetermined radiation, said microparticles are effective to release said image-forming agent, or said microparticles become permeable to a developer which is effective to react with said image-forming agent, to form a visible image.

2. Imaging material according to Claim 1, further characterised in that said image-forming agent is a chromogenic material and a developer material is associated with said imaging material which is capable of reacting with said chromogenic material and forming a visible image.

3. Imaging material according to Claim 1 or Claim 2, further characterised in that said polymer is a polyaldehyde.

4. Imaging material according to Claim 3, further characterised in that said polyaldehyde is a poly(aromatic dialdehyde) or a poly(aliphatic aldehyde).

5. Imaging material according to Claims 3 or 4, further characterised in that said polyaldehyde is end-capped with a photolabile or acid cleavable moiety.

6. Imaging material according to any preceding claim, further characterised in that said microparticle is chosen such that, after exposure, said microparticle is effective to release said image-forming agent or to become permeable to said developer by heating or by application of pressure following exposure.

7. Imaging material according to any preceding claim, further characterised in that said radiation comprises ultraviolet radiation or visible light.

8. Imaging material according to any preceding claim, further characterised in that said microparticles comprise a first set of microparticles containing a cyan image-forming material having a first sensitivity, a second set of microparticles containing a magenta image-forming material having a second sensitivity, and a third set of microparticles containing a yellow image-forming material having a third sensitivity, said first, second, and third sensitivities being sufficiently different that upon exposing said imaging material to a first said radiation, substantially only said first microparticles are effective to release image-forming material, upon exposing said imaging material to a second said radiation different from said first radiation, substantially only said second set of microparticles is effective to release image-forming material, and upon exposing said imaging material to a third said radiation different from said first and second radiations. substantially only said third set of microparticles is effective to release image-forming material.

9. Imaging material according to any preceding claim, further characterised in that said photosensitive composition additionally includes a photoinitiator.

10. Imaging material according to Claim 9, further characterised in that said photoinitiator is selected from triarylsulphonium hexafluorophosphates, triarylsulphonium arsenates, triarylsulphonium antimonates, diaryliodonium hexafluorophosphates, diaryliodonium arsenates, diaryliodonium antimonates, dialkylphenacylsulphonium tetrafluoroborates, dialkylphenacylsulphonium hexafluorophosphates, dialkyl-4-hydroxyphenylsulphonium tetrafluoroborates, and dialkyl-4-hydroxyphenylsulphonium hexafluorophosphates.

11. Imaging material according to Claim 1, further characterised in that said photosensitive composition includes an acid cleavable polymer and an onium salt as an initiator.

12. Imaging material according to Claim 11, further characterised in that said acid cleavable polymer is a polycarbonate.

13. Imaging material according to Claim 11, further characterised in that said acid cleavable polymer is a polyether.

14. Imaging material according to Claim 1, further characterised in that said photosensitive composition contains a polymer which is capable of undergoing cationically-initiated depolymerization and a photoinitiator including a silver halide and an organo silver salt, said microparticles being chosen such that, after exposure to radiation, they are effective directly or with additional processing to release said image-forming agent or to become permeable to a developer which is effective to react with said image-forming agent to form a visible image.

15. Imaging material according to Claim 14, further characterised in that said organosilver salt is selected from silver behanate, silver alkanesulphonic acid salts, silver perfluoroalkanesulphonic acid salts, and silver $\beta$-hydroperfluoroalkanesulphonic acid salts.

16. The imaging material of Claim 15, further characterised in that said organosilver salt is selected from silver dodecylsulphonate, silver hexadecylsulphonate, silver trifluoromethylsulphonate, silver pentafluoro-ethylsulphonate, silver perfluoropropylsulphonate, silver perfluoroctylsulphonate, $(CF_3)_2CHCF_2SO_3Ag$, and n-$C_3F_7CFHCF_2SO_3Ag$.

17. In image-forming process which comprises:

image-wise exposing to radiation an imaging material. characterised in that said imaging material comprises a support and a layer of photosensitive microparticles on one surface of said support, said microparticles including an image-forming agent and a photosensitive composition containing a depolymerizable polymer.

18. A process according to Claim 17, characterised in comprising the additional step of subjecting said imaging material to a treatment which induces said microparticles to release or exude said image-forming agent.

19. A process according to Claim 18, further characterised in that said treatment comprises heating and/or applying pressure to said layer of microparticles.

20. A process according to any of Claims 17, 18 or 19, further characterised in that said microparticles comprise a first set of microparticles containing a cyan image-forming material having a first sensitivity, a second set of microparticles containing a magenta image-forming material having a second sensitivity, and a third set of microparticles containing a yellow image-forming material having a third sensitivity, said first, second, and third sensitivities being sufficiently different that upon exposing said imaging material to a first radiation, substantially only said first microparticles are effective to release image-forming material, upon exposing said imaging material to a second radiation different from said first radiation, substantially only said second set of microparticles is effective to release image-forming material, and upon exposing said imaging material to a third radiation different from said first and second radiations, substantially only said third set of microparticles is effective to release image-forming material; and in that said step of image-wise exposing said imaging material to actinic radiation comprises sequentially or simultaneously image-wise exposing said imaging material to said first, second, and third radiations.

21. A process according to any of Claims 17 to 20, further characterised in that said photosensitive composition contains a polyaldehyde.

22. A process according to Claim 21, further characterised in that said polyaldehyde is a poly-(aromatic dialdehyde) or a poly(aliphatic aldehyde).

FIG-1

FIG-2

FIG-3

FIG-4

FIG-5

SUBJECT → COLOR RESOLUTION → IMAGE PROCESSING

-RED → λ → EXPOSURE → CYAN IMAGING SHEET → TRANSFER → DEVELOPER SHEET

-GREEN → λ → EXPOSURE → MAGENTA IMAGING SHEET → TRANSFER → DEVELOPER SHEET

-BLUE → λ → EXPOSURE → YELLOW IMAGING SHEET → TRANSFER → DEVELOPER SHEET

EP 0 295 344 A1

## FIG-6

```
SUBJECT → COLOR RESOLUTION → IMAGE PROCESSING
```

IMAGE PROCESSING branches to:
- -RED → λ-1 → EXPOSURE
- -GREEN → λ-2 → EXPOSURE
- -BLUE → λ-3 → EXPOSURE

All EXPOSURE paths → IMAGING SHEET → DEVELOPMENT → IMAGE

EP 0 295 344 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X,Y | US-D- 462 893 (R.W. NELSON) <br> * Whole document * <br> --- | 1-22 | G 03 F 7/00 <br> G 03 C 1/00 |
| X,D | US-A-3 917 483 (W.W. LIMBURG) <br> * Column 3, lines 62-67; claims * <br> --- | 1-22 | |
| X | US-A-3 951 658 (D.G. MARSH et al.) <br> * Whole document * <br> --- | 1-22 | |
| Y | EP-A-0 126 214 (IBM) <br> * Claims 1,10 * <br> --- | 1,5,10 | |
| D,Y | US-A-4 629 676 (Y. HAYAKAWA) <br> * Claims * <br> --- | 14-16 | |
| Y | GB-A- 780 218 (DU PONT) <br> * Claims * <br> --- | 14-16 | |
| D,Y | US-A-3 347 676 (H.N. CRIPPS) <br> * Claims * <br> --- | 14-16 | |
| X | CONFERENCE RECORD OF THE 1985 INTERNATIONAL DISPLAY RESEARCH CONFERENCE, San Diego, California, 15th-17th October 1985, pages 147-149, IEEE, New York, US; R.V. KOLLARITS et al.: "Color electronic imaging with mead microencapsulated paper" <br> * Whole article * <br> ----- | 1,20 | **TECHNICAL FIELDS SEARCHED (Int. Cl.4)** <br><br> G 03 F 7/00 <br> G 03 C 1/00 |

The present search report has been drawn up for all claims

| Place of search | Date of completion of the search | Examiner |
|---|---|---|
| THE HAGUE | 17-02-1988 | RASSCHAERT A. |